Europäisches Patentamt

European Patent Office

Office européen des brevets

(19)

(11) Numéro de publication: **0 027 066**

**B1**

(12) **FASCICULE DE BREVET EUROPEEN**

(45) Date de publication du fascicule du brevet: **06.07.83**

(51) Int. Cl.³: **G 10 L 1/04**

(21) Numéro de dépôt: **80401319.1**

(22) Date de dépôt: **16.09.80**

(54) Dispositif de détection de signaux vocaux et système d'alternat comportant un tel dispositif.

(30) Priorité: **28.09.79 FR 7924227**

(43) Date de publication de la demande:
**15.04.81 Bulletin 81/15**

(45) Mention de la délivrance du brevet:
**06.07.83 Bulletin 83/27**

(84) Etats contractants désignés:
**DE GB IT NL SE**

(56) Documents cités:
**FR - A - 2 380 612**
**US - A - 3 832 491**
**US - A - 4 052 568**

**IBM TECHNICAL DISCLOSURE BULLETIN vol.
11, no. 4, septembre 1968
New York US
G. A. HELLWARTH et al.: "Signal presence
detector with speechtone discrimination",
pages 417—419**

(73) Titulaire: **THOMSON-CSF
173, Boulevard Haussmann
F-75379 Paris Cedex 08 (FR)**

(72) Inventeur: **Dumont, François
"THOMSON-CSF" - SCPI 173, Bld Haussmann
F-75360 Paris Cedex 08 (FR)**

(74) Mandataire: **Turlèque, Clotilde et al,
THOMSON-CSF SCPI 173, Bld Haussmann
F-75379 Paris Cedex 08 (FR)**

(56) Documents cités
**IEEE TRANSACTIONS ON COMMUNICATIONS
vol. COM-26, no. 1, janvier 1978
New York US
P. G. DRAGO et al.: "Digital dynamic speech
detectors", pages 140—145**

Courier Press, Leamington Spa, England.

Dispositif de détection de signaux vocaux et système d'alternat comportant un tel dispositif

La présente invention concerne les dispositifs de détection de signaux vocaux dans un signal d'entrée, en particulier ceux qui équipent les systèmes d'alternat.

De tels dispositifs fournissent une information logique, présence ou absence de parole, pouvant être utilisée pour commander, par exemple, un interrupteur afin de discriminer les signaux vocaux du signal d'entrée.

Toute troncature de début ou de fin d'activité vocale est en général supprimée par l'adjonction d'une ligne à retard précédant l'interrupteur et retardant le signal d'entrée audiofréquence.

Il est actuellement connu de réaliser des dispositifs simples de commande d'alternat à la voix basés sur la comparaison de la seule énergie du signal d'entrée par rapport à un seuil fixe. Mais les performances de tels dispositifs en milieu bruyant sont insuffisantes.

Il est connu aussi, par le brevet US 3 832 491, de réaliser un seuil variable dont la variation est commandée en fonction du nombre de fois où le seuil est dépassé pendant une période fixée. Si ce nombre de dépassements est supérieur à une valeur fixée, la valeur du seuil est augmentée, et inversement dans le cas contraire. Ce procédé est meilleur mais a des performances encore insuffisantes.

Des dispositifs plus performants, basés essentiellement sur l'analyse spectrale du signal sont également connus, mais ils donnent lieu à des réalisations complexes.

La présente invention a pour objet de remédier à ces inconvénients à l'aide de moyens simples.

Selon l'invention, un dispositif de détection de signaux vocaux dans un signal d'entrée en milieu bruyant, comportant des moyens d'asservissement non linéaire d'une tension de seuil sur la valeur de l'amplitude crête du signal d'entrée; des moyens d'atténuation du signal dentrée dans un rapport k (k entier positif non nul); et des moyens de comparaison de l'amplitude du signal d'entrée atténuée par rapport à la tension de seuil variable ayant une sortie délivrant un premier signal de commande intermédiaire lorsque l'amplitude du signal d'entrée atténué est supérieure à la tension de seuil; est caractérisé en ce que les moyens d'asservissement non linéaire fournissent une tension de seuil croissante en fonction du temps suivant une constante de temps $\tau_m$ lorsque l'amplitude de crête du signal d'entrée est supérieure à la tension de seuil, et décroissante suivant une constante de temps $\tau_d$ dans le cas contraire, la décroissance commençant avec un retard déterminé $T_m$, la constante de temps $\tau_m$ étant choisie supérieure à la durée syllabique maximale, la constante de temps $\tau_d$ étant choisie telle que la tension de seuil redescende au niveau du bruit entre deux syllabes et le

retard $T_m$ étant un majorant de la période de mélodie; et en ce qu'il comporte des moyens de décision couplés à la sortie des moyens de comparaison et effectuant une analyse temporelle des dépassements de la tension de seuil par l'amplitude du signal d'entrée atténué, afin de délivrer un signal de commande principal correspondant à une détection de présence de signaux vocaux.

L'invention sera mieux comprise et d'autres caractéristiques apparaîtront à l'aide de la description ci-après et des schémas s'y rapportant sur lesquels.

— la figure 1 est un exemple d'un mode de réalisation du dispositif selon l'invention;

— la figure 2 représente le chronogramme des signaux permettant d'expliquer le fonctionnement du dispositif de la figure 1.

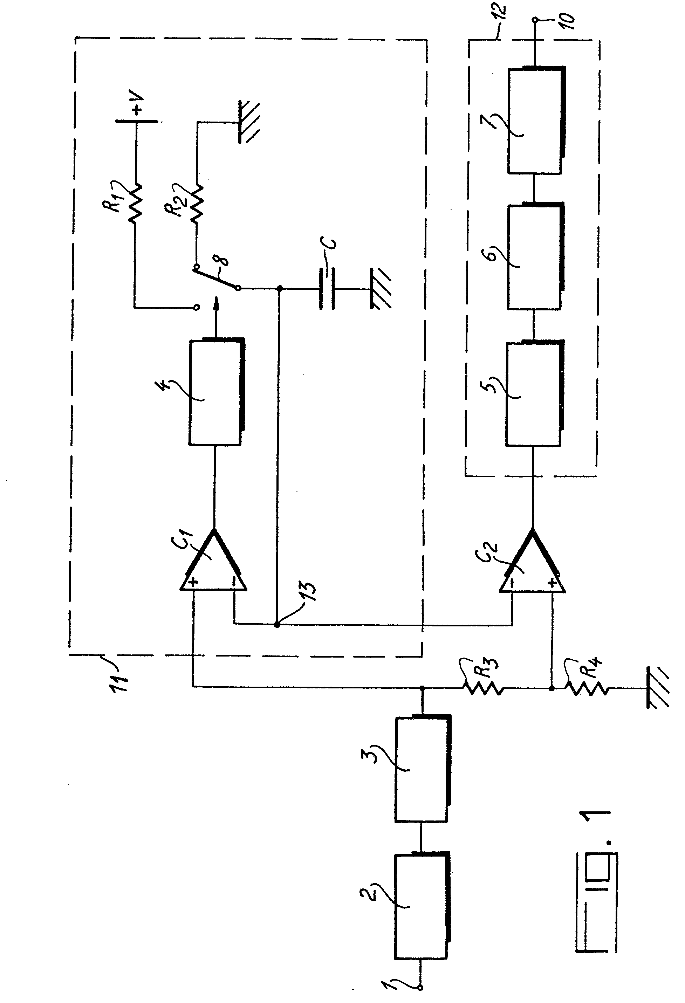

Sur la figure 1, une borne d'entrée 1, destinée à recevoir un signal d'entrée constitué par un signal de parole mêlé de bruit, est couplée à l'entrée d'un amplificateur 3 à travers un redresseur mono-alternance 2. La sortie de l'amplificateur 3 est couplée à l'entrée "+" d'un comparateur $C_2$ à travers une résistance $R_2$ et à l'entrée "+" d'un comparateur $C_1$. L'entrée "+" du comparateur $C_2$ est en outre couplée à la masse à travers une résistance $R_4$. Les entrées "—" des comparateurs $C_1$ et $C_2$ sont couplées à la masse à travers un condensateur C et à une extrémité d'un commutateur 8. Ce commutateur 8 permet de coupler cette extrémité soit à une source de tension "+V" à travers une résistance $R_1$, soit à la masse à travers une résistance $R_2$. La sortie du comparateur $C_1$ est couplée à l'entrée de commande de ce commutateur 8 à travers un premier monostable 4. La sortie du comparateur $C_2$ est couplée à une borne de sortie 10 à travers un deuxième monostable 5, un troisième monostable 6 et un quatrième monostable 7 disposés en série.

L'ensemble formé par le comparateur $C_1$, le premier monostable 4, le commutateur 8, le condensateur C, les résistances $R_1$ et $R_2$ constituent des moyens 11 d'asservissement non linéaire d'une tension de seuil.

De même, les deuxième, troisième et quatrième monostables 5, 6 et 7 forment des moyens de décision 12.

Avant de décrire le fonctionnement de ce dispositif, il est utile de rappeler tout d'abord que les différents sons constituant un signal vocal peuvent être classés suivant leur mode de production, en sons voisés et non voisés.

Les sons voisés sont constitués soit par des voyelles, soit par des consonnes liquides ou sonores, et possèdent des propriétés spectrales bien définies qui ne se retrouvent pas dans les sons non voisés constitués par les consonnes sourdes. Les sons voisés, dont l'amplitude est généralement beaucoup plus importante que celle des sons non voisés, présentent une périodicité très marquée au niveau du signal, temporel. Cette périodicité qui n'existe pas pour les sons non voisés est due à la vibration des cordes vocales. La valeur de la fréquence correspondant à cette périodicité, appelée fréquence de mélodie, peut être comprise, suivant les personnes, entre environ 60 et 300 Hz.

Il est donc clair qu'il est beaucoup plus facile de discriminer du bruit les sons voisés plutôt que les sons non voisés, qui, de par leurs caractéristiques spectrales et d'amplitudes, seront généralement "noyés" dans le bruit de fond.

Pour garantir des performances maximales, le dispositif représenté sur la figure 1 permet d'optimiser la discrimination pour les sons voisés. Pour cela, la décision présence ou absence de parole est élaborée à partir de l'analyse de l'amplitude instantanée du signal vocal plutôt que son énergie et se fait en trois étapes:

a) Asservissement non linéaire d'une tension de seuil sur la valeur de l'amplitude crête du signal d'entrée afin de s'affranchir de la valeur absolue du bruit de fond et de ne garder comme paramètre de discrimination que la valeur relative du rapport d'amplitude parole sur bruit. Cet asservissement est effectué par les moyens d'asservissement 11 qui délivrent une tension de seuil, soit exponentiellement croissante en fonction du temps suivant une constante de temps $\tau_m$ lorsque l'amplitude instantanée du signal d'entrée audiofréquence est supérieure à la tension de seuil, soit exponentiellement décroissante suivant une constante de temps $\tau_d$ lorsque l'amplitude instantanée du signal d'entrée est inférieure à la tension de seuil.

b) Comparaison de l'amplitude instantanée du signal d'entrée audiofréquence atténué d'un rapport k (k : entier non nul) par rapport à la tension de seuil générée par les moyens d'asservissement 11. Cette comparaison est effectuée par le comparateur $C_2$ qui délivre un signal logique de niveau 1 lorsque cette amplitude est supérieure à la tension de seuil.

c) Analyse temporelle du signal de sortie du comparateur $C_2$ de façon à exploiter les caractéristiques particulières des sons voisés, et extension par proximité de la décision d'activité vocale (procédure décrite dans le brevet français THOMSON-CSF 2 380 612) pour remédier aux troncatures des sons non voisés. En effet les sons non voisés que l'on peut à quelques exceptions près assimiler aux consonnes sont presque toujours directement précédés ou suivis par une voyelle, c'est-à-dire un son voisé. Dans ces conditions il suffit pour éviter les troncatures de prolonger de quelques dizaines de millisecondes la décision prise sur un son voisé. En pratique, le signal d'entrée est retardé dans une ligne à retard et la décision d'activité prise sur un son voisé est prolongée de deux fois le retard apporté par cette ligne à retard.

En outre, l'analyse temporelle du signal de sortie du comparateur $C_2$ se fait suivant un double critère temporel qui permet d'exploiter, d'une part la fréquence de mélodie par test du temps maximal séparant deux transitions de l'état "0" à l'état "1" du signal analysé, et d'autre part la fréquence syllabique par test du temps pendant lequel les transitions rythmées existent.

L'analyse temporelle du signal de sortie du comparateur $C_2$ et l'extension par proximité de la détection d'activité vocale sont effectuées par les moyens de décision 12.

Ces moyens de décision 12 décident qu'il y a présence de sons voisés quand les trois conditions suivantes sont remplies simultanément:

1) L'amplitude instantanée du signal audiofréquence dépasse la tension de seuil variable

2) Le temps séparant deux transitions de l'état "0" à l'état "1" du signal de sortie du comparateur $C_2$ ne dépasse pas un majorant $T_m$ de la période de mélodie

3) Ces transitions durent un temps au moins égal à un monorant $T_s$ de la période syllabique.

Ces conditions ont été établies de façon à être satisfaites en présence de sons voisés d'énergie suffisante, à condition toutefois que la tension de seuil ne varie que très peu pendant la détection.

Ceci entraine que la constante de temps $\tau_m$ d'accroissement de la tension de seuil variable doit être supérieure à la durée syllabique. Pour cela la valeur de cette constante de temps $\tau_m$ à la montée est choisie de l'ordre de 5s. D'autre part, pour garder les mêmes performances de détection sur un débit vocal continu, il est nécessaire que la tension de seuil redescende rapidement au niveau du bruit entre deux syllabes et donc que la constante de temps de descente $\tau_d$ soit beaucoup plus faible que celle de montée. Pour cela la valeur de cette constante $\tau_d$ est choisie de l'ordre de 200 ms.

De plus, compte tenu des critères de détection précédents, l'immunité aux bruits repose sur les moyens d'asservissement de la tension de seuil. La tension de seuil doit avoir une valeur telle qu'en présence du bruit, au moins une des trois conditions de détection précédentes ne soit pas vérifiée.

Il peut être mis en évidence trois types de bruits différents facilement rejetables en imposant des conditions d'asservissement de la tension de seuil.

Ainsi pour des bruits du type "stationnaire modulé" dont les variations d'énergie moyenne sont très lentes, mais qui présentent une modulation importante à fréquence supérieure ou égale à la fréquence de mélodie, les conditions de décision ② et ③ sont en général vérifiées. Afin d'éviter que la condition ① soit aussi vérifiée en présence d'un tel bruit, la tension de seuil doit être régulée sur les crêtes d'amplitude dont la fréquence de récurrence peut être confondue avec la fréquence de mélodie. Cette condition peut être réalisée en

prolongeant la commande d'accroissement de la tension de seuil d'un temps au moins égal à $T_m$ (période maximale de mélodie), après que l'amplitude instantanée du signal audiofréquence soit redescendue en dessous de la tension de seuil. Ce rôle est rempli par le monostable 4 de la figure 1.

Les bruits du type "stationnaire blanc", dont les variations d'énergie moyenne, comme ceux de la catégorie précédente, sont assez lentes, ne présentent pas de périodicité mélodique mais une répartition d'amplitudes dont la densité de probabilité décroît rapidement quand l'amplitude augmente (type gaussien par exemple). Pour de tels bruits, l'amplitude instantanée pouvant prendre de très grandes valeurs, la condition de décision ① est en général vérifiée. Il est toutefois possible de rejeter un tel bruit si la probabilité d'avoir pendant le temps $T_s$ plusieurs dépassements de la tension de seuil par l'amplitude du signal séparés par un temps inférieur à $T_m$, est quasi nulle (c'est-à-dire que les conditions ② et ③ ne soient pas vérifiées). Ceci peut être réalisé en atténuant le signal qui est comparé à la tension de seuil pour la décision d'activité vocale, par rapport au signal qui sert à générer la tension de seuil. En effet, en présence d'un bruit de ce type, le système d'asservissement régule la valeur moyenne de la tension de seuil en fonction de la probabilité de dépassement de la tension de seuil par l'amplitude du signal d'entrée non atténué. Cette probabilité est fixée par les paramètres $T_m$ et $\tau_m/\tau_d$. Le choix du facteur d'atténuation k permet donc de faire tendre vers zéro la probabilité de dépassement de la tension de seuil par le signal atténué quand il s'agit d'un bruit, sans pratiquement modifier cette probabilité d'intersection en présence de sons voisés. Ce rôle d'atténuation est rempli par le diviseur potentiométrique composé des deux résistances $R_3$ et $R_4$.

Enfin, les bruits de type "impulsionnel" dont la durée est inférieure à $T_s$ quelles que soient leurs énergies ou les fréquences qu'il contiennent, produisent généralement des dépassements de la tension de seuil par l'amplitude instantanée du signal, et satisfont ainsi aux conditions de décision ① et ②. Seule la condition ③ permet de rejeter ces bruits.

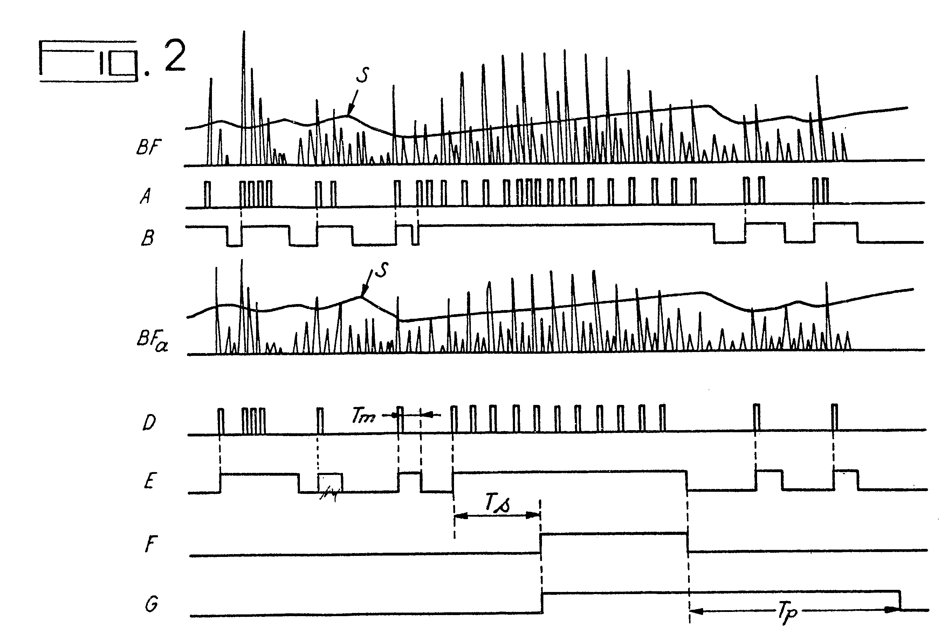

La réalisation pratique de moyens de décision mettant en oeuvre les critères de décision ①, ② et ③, et de moyens d'asservissement d'une tension de seuil présentant les caractéristiques définies précédemment, peut se faire de façon simple en utilisant les éléments décrits sur la figure 1. Le chronogramme de fonctionnement de ces éléments est donné sur la figure 2.

Sur cette figure 2, sont représentés des signaux BF, A, B, $BF_a$, D, E, F et G respectivement présents à la sortie de l'amplificateur 3, à la sortie du comparateur $C_1$, à la sortie du monostable 4, à l'entrée "+" du comparateur $C_2$, à la sortie du comparateur $C_2$, à la sortie du monostable 5, à la sortie du monostable 6, et à la sortie du monostable 7.

L'amplitude de la tension de seuil (notée S) à été superposée aux signaux BF et $BF_a$.

Le signal BF, présent, à la sortie de l'amplificateur 3, correspond au signal d'entrée audiofréquence redressé mono-alternance par le redresseur 2, puis amplifié par l'amplificateur 3 pour couvrir la plage d'amplitude maximale. L'amplitude de ce signal BF est ensuite comparée à la tension de seuil variable S par le comparateur $C_1$. Ce comparateur fournit le signal logique A qui passe à l'état haut quand l'amplitude instantanée du signal BF est supérieure à la tension de seuil et à l'état bas dans le cas contraire. Ce signal est appliqué à l'entrée du monostable 4 dont le signal logique de sortie B passe à l'état haut en même temps que son signal d'entrée, mais ne repasse à l'état bas que $T_m$ millisecondes après que son signal d'entrée soit stabilisé à l'état bas. $T_m$ qui est égal à 16 ms représente un majorant de la période dé mélodie présente dans le signal vocal.

Le signal de sortie B du monostable 4 commande un intégrateur dissymétrique constitué par les résistances $R_1$ et $R_2$, le commutateur 8 et le condensateur C. La sortie 13 de cet intégrateur délivre la tension de seuil variable de telle façon que lorsque le signal de commande B est à l'état haut, la valeur de la tension de seuil s'accroisse selon une loi exponentielle de constante de temps $R_1C$ de l'ordre de 5s et que, lorsque le signal de commande est à l'état bas, la valeur de la tension de seuil diminue suivant la même loi, mais avec une constante de temps $R_2C$ de l'ordre de 200 ms.

Le diviseur potentiométrique formé par les résistances $R_3$ et $R_4$ permet d'atténuer d'un rapport k le signal de sortie BF de l'amplificateur 3. Le signal atténué $BF_a$ est ensuite comparé à la tension de seuil variable par le comparateur $C_2$. Le signal de sortie D de ce comparateur $C_2$ est appliqué à l'entrée d'un monostable 5 dont le signal logique de sortie E passe à l'état haut quand la valeur de l'amplitude du signal $BF_a$ devient supérieure à la tension de seuil, et ne repasse à l'état bas que $T_m$ millisecondes après que l'amplitude du signal $BF_a$ soit redescendue en dessous du seuil. Le signal logique E est appliqué à l'entrée du monostable 6. Le signal logique de sortie F de ce monostable 6 ne passe à l'état haut que $T_s$ millisecondes après que son signal d'entrée soit stabilisé à l'état haut, et ne repasse à l'état bas qu'en synchronisme avec son signal d'entrée. Le dernier monostable 7 fournit un signal logique G qui passe à l'état haut en même temps que le signal de sortie F du monostable 6 et indique ainsi la présence de sons voisés. Ce signal G indique une fin de ces sons voisés quand il repasse à l'état bas, $T_p$ millisecondes après le signal de sortie F du monostable 6, $T_p$ est égal à $T_s$ plus deux fois 20 ms constituant l'extension par proximité. Pour discriminer les signaux de parole de signal BF, il suffira, par exemple, de commander un interrupteur (non représenté) par le signal G.

De plus, une ligne à retard (non représentée) associée au détecteur retardera le signal audiofréquence BF de $T_s + 20$ ms, afin de supprimer le décalage entre le signal de décision G et le signal audiofréquence BF.

Le dispositif qui vient d'être décrit présente l'avantage d'une immuinité quasi totale à tout bruit présentant des variations lentes quel qu'en soit le niveau et à tout bruit impulsionnel de durée inférieure à environ 50 ms quelle qu'en soit l'amplitude.

De plus, la détection de sons voisés se fait avec une bonne précision temporelle malgré un rapport signal sur bruit faible.

Enfin, le dispositif décrit présente la possibilité de supprimer toute troncature de début ou de fin d'activité vocale grâce à l'adjonction d'une ligne à retard permettant de retarder le signal audiofréquence.

L'invention n'est pas limitée au mode de réalisation décrit et représenté, en particulier, il est à la portée de l'homme de l'art de réaliser des moyens d'asservissement non linéaires qui génèrent une tension de seuil présentant les caractéristiques exposées.

**Revendications**

1. Dispositif de détection de signaux vocaux dans un signal d'entrée en milieu bruyant, comportant des moyens d'asservissement non linéaire (11) d'une tension de seuil sur la valeur de l'amplitude crête du signal d'entrée, des moyens d'atténuation ($R_3$ et $R_4$) du signal d'entrée dans un rapport k (k entier positif non nul); et des moyens de comparaison ($C_2$) de l'amplitude du signal d'entrée atténuée par rapport à la tension de seuil variable ayant une sortie délivrant un premier signal de commande intermédiaire lorsque l'amplitude du signal d'entrée atténué est supérieure à la tension de seuil; caractérisé en ce que les moyens d'asservissement non linéaire (11) fournissant une tension de seuil croissante en fonction du temps suivant une constante de temps $\tau_m$ lorsque l'amplitude de crête du signal d'entrée est supérieure à la tension de seuil, et décroiss-ante suivant une constante de temps $\tau_d$ dans le cas contraire, la décroissance commençant avec un retard déterminé $T_m$, la constante de temps $\tau_m$ étant choisie supérieure à la durée syllabique maximale, la constante de temps $\tau_d$ étant choisie telle que la tension de seuil redescende au niveau du bruit entre deux syllabes, et le retard $T_m$ étant un majorant de la période de mélodie; et en ce qu'il comporte des moyens de décision (12) couplés à la sortie des moyens de comparaison ($C_2$) et effectuant une analyse temporelle des dépassements de la tension de seuil par l'amplitude du signal d'entrée atténué, afin de délivrer un signal de commande principal correspondant à une détection de présence de signaux vocaux.

2. Dispositif de détection selon la revendication 1, caractérisé en ce que les moyens d'asservissement non linéaire (11) comportent: un générateur de tension ($R_1$, $R_2$, +V et C) ayant une entrée de commande, et une sortie délivrant une tension soit exponentiellement croissante en fonction du temps suivant la constante de temps $\tau_m$, soit exponentiellement décroissante suivant la constante de temps $\tau_d$, la tension délivrée par ce générateur servant de tension de seuil; des moyens de commande (4 et $C_1$) du générateur ayant une première et une deuxième entrée recevant respectivement le signal d'entrée et la tension de seuil, et une sortie couplée à l'entrée de commande du générateur et délivrant un signal de commande auxiliaire pour commander le sens de variation de la tension de seuil générée par le générateur.

3. Dispositif de détection selon la revendication 1, caractérisé en ce que les moyens de décision comportent: un premier temporisateur (5) ayant une entrée couplée à la sortie des moyens de comparaison ($C_2$) et une sortie délivrant un deuxième signal de commande intermédiaire correspondant au premier signal prolongé d'une durée égale à la période maximale de mélodie; un deuxième temporisateur (6) ayant une entrée couplée à la sortie du premier temporisateur et une sortie délivrant le signal de commande principal lorsque la durée du premier signal est supérieure à la durée syllabique minimum, ce signal de commande principal correspondant à la présence de sons voisés dans le signal d'entrée.

4. Dispositif de détection selon la revendication 2, caractérisé en ce que les moyens de commande comportent: un comparateur ($C_1$) ayant une première entrée recevant le signal d'entrée et une deuxième entrée recevant la tension de seuil délivrée par le générateur et une sortie délivrant un signal de commande auxiliaire intermédiaire lorsque, l'amplitude du signal d'entrée est supérieure à la tension de seuil; et un temporisateur (4) ayant une entrée couplée à la sortie du comparateur, et une sortie délivrant le signal de commande auxiliaire correspondant au signal de commande auxiliaire intermédiaire prolongé d'une durée supérieure à la période maximale de mélodie.

5. Dispositif de détection selon la revendication 2, caractérisé en ce que le générateur de tension comporte: un commutateur (8) ayant une entrée de commande correspondant à l'entrée de commande du générateur; une capacité (C) ayant une première extrémité couplée à la masse et une deuxième extrémité couplée soit à la masse à travers une première résistance ($R_2$), soit à une source de tension (+V) à travers une deuxième résistance ($R_1$), cette deuxième extrémité constituant la sortie du générateur.

6. Système d'alternat caractérisé en ce qu'il comporte un dispositif de détection selon l'une des revendications 1 à 5.

## Patentansprüche

1. Detektorvorrichtung für Sprachsignale, die in einem Eingangssignal in geräuschvoller Umgebung enthalten sind, mit einer nichtlinearen Regeleinrichtung (11) zum Regeln einer Schwellspannung auf den Spitzenamplitudenwert des Eingangssignals; Mitteln ($R_3$ und $R_4$) zur Dämpfung des Eingangssignals in einem Verhältnis k (k ganzzahlig positiv und ungleich Null); und Mitteln ($C_2$) zum Vergleichen der Amplitude des gedämpften Eingangssignals mit der variablen Schwellspannung, deren Ausgang ein erstes Zwischensteuersignal abgibt, wenn die Amplitude des gedämpften Eingangssignals größer als die Schwellspannung ist; dadurch gekennzeichnet, daß die nichtlineare Regeleinrichtung (11) eine Schwellspannung liefert, die in Abhängigkeit von der Zeit mit einer Zeitkonstante $\tau_m$ zunimmt, wenn die Spitzenamplitude des Eingangssignals größer als die Schwellspannung ist, und im entgegengesetzten Fall mit einer Zeitkonstante $\tau_d$ abnimmt, wobei die Abnahme mit einer vorbestimmten Verzögerung $T_m$ beginnt, die Zeitkonstante $\tau_m$ größer als die maximale Dauer einer Silbe gewählt ist, die Zeitkonstante $\tau_d$ so gewählt ist, daß die Schwellspannung zwischen zwei Silben wieder auf den Pegel des Geräusches absinkt, und die Verzögerung $T_m$ eine Verlängerung der Melodieperiode bildet; und daß sie Entscheidungsmittel (12) umfaßt, die an den Ausgang der Vergleichermittel ($C_2$) angekoppelt sind und eine zeitliche Analyse der Überschreitung der Schwellspannung durch die Amplitude des gedämpften Eingangssignals durchführt, um ein Hauptsteuersignal zu erzeugen, welches der Erfassung von Sprachsignalen entspricht.

2. Detektorvorrichtung nach Anspruch 1, dadurch gekennzeichnet, daß die nichtlineare Regeleinrichtung (11) umfaßt: einen Spannungsgenerator ($R_1$, $R_2$ +V und C), der einen Steuereingang und einen Ausgang aufweist, welcher eine Spannung abgibt, die entweder zeitabhängig mit einer Zeitkonstante $\tau_m$ exponentiell zunimmt oder mit einer Zeitkonstante $\tau_d$ exponentiell abnimmt, wobei die von diesem Generator abgegebene Spannung als Schwellspannung dient; Steuermittel (4 und $C_1$) zur Steuerung des Generators, mit einem ersten und einem zweiten Eingang, von denen der erste das Eingangssignal und der zweite die Schwellspannung empfängt, und einem an den Steuereingang des Generators angekoppelten Ausgang, der ein Hilfssteuersignal abgibt, um den Änderungssinn der von dem Generator erzeugten Schwellspannung zu steuern.

3. Detektorvorrichtung nach Anspruch 1, dadurch gekennzeichnet, daß die Entscheidungsmittel umfassen: eine erste Zeitverzögerungseinrichtung (5), deren Eingang mit dem Ausgang der Vergleichermittel ($C_2$) verbunden ist und deren Ausgang ein zweites Zwischensteuersignal abgibt, das dem ersten Signal entspricht, welches um eine Dauer verlängert ist, die gleich der maximalen Melodieperiode ist; eine zweite Zeitverzögerungseinrichtung (6), die einen mit dem Ausgang der ersten Zeitverzögerungseinrichtung verbundenen Eingang und einen Ausgang aufweist, der das Hauptsteuersignal abgibt, wenn die Dauer des ersten Signals größer als die minimale Silbendauer ist, wobei dieses Hauptsteuersignal der Anwesenheit von stimmhaften Klängen in dem Eingangssignal entspricht.

4. Detektorvorrichtung nach Anspruch 2, dadurch gekennzeichnet, daß die Steuermittel umfassen: einen Vergleicher ($C_1$), dessen erster Eingang das Eingangssignal und dessen zweiter Eingang die von dem Generator abgegebene Schwellspannung empfängt und dessen Ausgang ein Zwischen-Hilfssteuersignal abgibt, wenn die Amplitude des Eingangssignals größer als die Schwellspannung ist; und eine Zeitverzögerungseinrichtung (4), deren Eingang an den Ausgang des Vergleichers angekoppelt ist und deren Ausgang das Hilfssteuersignal abgibt, welches dem Zwischen-Hilfssteuersignal entspricht, das um eine Dauer verlängert ist, die größer als die maximale Melodieperiode ist.

5. Detektorvorrichtung nach Anspruch 2, dadurch gekennzeichnet, daß der Spannungsgenerator umfaßt: einen Schalter (8) mit einem Steuereingang, der dem Steuereingang des Generators entspricht; eine Kapazität (C), deren erster Anschluß mit Masse und deren zweiter Anschluß entweder über einen ersten Widerstand ($R_2$) mit Masse oder über einen zweiten Widerstand ($R_1$) mit einer Spannungsquelle (+V) verbunden ist, wobei dieser zweite Anschluß den Ausgang des Generators bildet.

6. Umschaltsystem, dadurch gekennzeichnet, daß es eine Detektorvorrichtung nach einem der Ansprüche 1 bis 5 umfaßt.

## Claims

1. Device for the detection of speech signals contained in an input signal in a noisy environment, comprising non-linear slaving means (11) for slaving a threshold voltage to the peak amplitude value of the input signal; means ($R_3$ and $R_4$) for attenuation of the input signal at the ratio k (k positive integer unequal zero); and means ($C_2$) for comparing the attenuated input signal amplitude with the variable threshold voltage having an output supplying a first intermediate control signal when the amplitude of the attenuated input signal exceeds the threshold voltage; characterized in that the non-linear slaving means (11) provide a threshold voltage increasing in dependence on the time in accordance with a time constant $\tau_m$ when the peak amplitude of the input signal exceeds the threshold voltage, and decreases in accor-dance with a time constant $\tau_d$ in the contrary case, the reduction beginning after a determined delay

$T_m$, the time constant $\tau_m$ being selected in excess of the maximum syllable duration, the time constant $\tau_d$ being selected in such a manner that the threshold value will drop to the level of the noise between two syllables, and the delay $T_m$ being added to the melody period; and in that it comprises decision means (12) coupled to the output of the comparing means $(C_2)$ and performing a temporal analysis of the excesses of the threshold voltage by the attenuated input signal amplitude in order to supply a main control signal corresponding to the detection of speech signal presence.

2. Detector device in accordance with claim 1, characterized in that the non-linear slaving means (11) comprise: A voltage generator ($R_1$, $R_2$, +V and C) having a control input, an output supplying a voltage either increasing exponentially in dependence on time in accordance with the time constant $\tau_m$, or decreasing exponentially in accordance with the time constant $\tau_d$, the voltage supplied by this generator being used as the threshold voltage, control means (4 and $C_1$) for controlling the generator, having first and second inputs receiving the input signal and the threshold voltage, respectively, and an output coupled to the control input of the generator and supplying an auxiliary control signal for controlling the sense of variation of the threshold voltage generated by the generator.

3. Detector device in accordance with claim 1, characterized in that the decision means comprise: First timing means (5) having in input coupled to the output of the comparing means $(C_2)$ and an output supplying a second intermediate control signal corresponding to the first signal extended by a duration which is equal to the maximum melody period; second timing means (6) having an input coupled to the output of the first timing means and an output supplying the main control signal when the duration of the first signal exceeds the minimum syllable duration, this main control signal corresponding to the presence of voiced sounds within the input signal.

4. Detector device in accordance with claim 2, characterized in that the control means comprise: A comparator $(C_1)$ having a first input receiving the input signal and a second input receiving the threshold voltage supplied by the generator, and an output supplying an auxiliary, intermediate control signal when the amplitude of the input signal exceeds the threshold voltage; and timing means (4) having an input coupled to the output of the comparator, and an output supplying the auxiliary control signal corresponding to the auxiliary, intermediate control signal extended by a duration exceeding the maximum melody period.

5. Detector device in accordance with claim 2, characterized in that the voltage generator comprises: a switch (8) having a control input corresponding to the control input of the generator; a capacity (C) having a first terminal coupled to ground and a second terminal coupled either to ground through a first resistor $(R_2)$ or to a voltage source (+V) through a second resistor $(R_1)$, this second terminal forming the output of the generator.

6. Switching system, characterized in that it comprises a detector device in accordance with any of claims 1 to 5.

0 027 066

Fig. 1

Fig. 2